# EUROPEAN PATENT APPLICATION

(11) **EP 4 727 099 A1**
(43) Date of publication of application: **15.04.2026**
(21) Application number: 24843561.2
(22) Date of filing: 19.07.2024
(51) Int. Cl.: H04M 1/02, H04M 1/22, H05K 5/02, F21V 29/54, F21V 29/503, F21V 33/00, F21V 29/85, C01B 32/20, G06F 1/16, G03B 15/02, G03B 15/05, G06F 1/20, G03B 21/16

(54) **ELECTRONIC DEVICE COMPRISING AT LEAST ONE LIGHT SOURCE AND HEAT DISSIPATION STRUCTURE**

(30) Priority: 20.07.2023 KR 20230094753; 19.09.2023 KR 20230124666
(71) Applicant: Samsung Electronics Co., Ltd., Suwon-si, Gyeonggi-do 16677 (KR)
(72) Inventor: YEO, Donghyeon, Suwon-si, Gyeonggi-do 16677 (KR); KIM, Yongwoon, Suwon-si, Gyeonggi-do 16677 (KR); KIM, Heekon, Suwon-si, Gyeonggi-do 16677 (KR); LEE, Sangwon, Suwon-si, Gyeonggi-do 16677 (KR)
(74) Representative: HGF
(86) International application number: PCT/KR2024/010500
(87) International publication number: WO 2025/018850

(57) **Abstract**

An electronic device is provided. The electronic device may comprise: a cover including a first surface, which is a part of the outer surface of the electronic device, and a second surface, which faces the opposite direction of the first surface and includes a light transmission portion; a substrate arranged in the inner space of the electronic device; a light source, which is arranged on the substrate and irradiates light toward the light transmission portion; and a heat dissipation sheet which is attached to the second surface of the cover so as to encompass at least a portion of the light transmission portion on the second surface of the cover, and which includes a heat diffusion member and a light reflection member.

## Description

### [Technical Field]

The disclosure relates to an electronic device including at least one light source and a heat dissipation structure for the at least one light source.

### [Background Art]

With the development of information and communication technology and semiconductor technology, various functions are packed in one portable electronic device (e.g., a smartphone). For example, an electronic device may implement not only communication functions but also entertainment functions, such as playing games, multimedia functions, such as playing music and videos, communication and security functions for mobile banking, camera functions for capturing images/videos, and scheduling or e-wallet functions. These electronic devices have been downsized to be conveniently carried by users.

Portable electronic devices may include a flash used for a variety of purposes, such as for use as a flashlight in an emergency, sending/receiving messages, such as calls or texts, and/or displaying notifications, such as alarms. This flash typically includes a light emitting diode (LED) and may be referred to as a flash LED, and may have the principle of emitting light through the electroluminescence effect. The flash LED in the portable electronic device may cause local heating that may lead to concerns about accidents. Thus, the performance standards for such product are rising. A predetermined period of time after the flash LED turns on, the temperature of the surroundings may rise up to 45 degrees Celsius. This leads to the need for means for monitoring the temperature of the flash LED and controlling the flash LED.

The above information is presented as background information only to assist with an understanding of the disclosure. No determination has been made, and no assertion is made, as to whether any of the above might be applicable as prior art with regard to the disclosure.

### [Disclosure of Invention]

### [Solution to Problems]

Aspects of the disclosure are to address at least the above-mentioned problems and/or disadvantages and to provide at least the advantages described below. Accordingly, an aspect of the disclosure is to provide an electronic device including at least one light source and a heat dissipation structure for the at least one light source.

Additional aspects will be set forth in part in the description which follows and, in part, will be apparent from the description, or may be learned by practice of the presented embodiments.

In accordance with an aspect of the disclosure, an electronic device is provided. The electronic device includes a cover including a first surface which is a portion of an outer surface of the electronic device and a second surface facing in a direction opposite to the first surface, and including a light transmission portion, a substrate disposed in an inner space of the electronic device, a light source disposed on the substrate to emit light through the light transmission portion, and a heat dissipation sheet attached on the second surface of the cover to surround at least a portion of the light transmission portion, wherein the heat dissipation sheet includes a heat diffusion member, and a light reflection member.

In accordance with another aspect of the disclosure, an electronic device is provided. The electronic device includes a cover including a first surface which is a portion of an outer surface of the electronic device and a second surface facing in a direction opposite to the first surface, and including a light transmission portion, a substrate disposed in an inner space of the electronic device, a light source disposed on the substrate to emit flash light through the light transmission portion, and a light reflection member disposed on the second surface of the cover to surround at least a portion of the light transmission portion, wherein the light reflection member is configured to reflect a portion of the flash light, emitted by the light source, in a direction toward the inner space from the cover.

In accordance with another aspect of the disclosure, an electronic device is provided. The electronic device includes a cover including a first surface and a second surface facing in a direction opposite to the first surface, wherein a portion of the cover includes a light transmission portion , a substrate disposed in an inner space of the electronic device, at least one light source disposed on the substrate to emit light through the light transmission portion, and a heat dissipation sheet disposed on the second surface of the cover to surround at least a portion of the light transmission portion, wherein the heat dissipation sheet includes a heat insulation member and a light reflection member, and wherein the heat dissipation sheet is attached to the second surface of the cover.

Other aspects, advantages, and salient features of the disclosure will become apparent to those skilled in the art from the following detailed description, which, taken in conjunction with the annexed drawings, discloses various embodiments of the disclosure.

### [Brief Description of Drawings]

The above and other aspects, features, and advantages of certain embodiments of the disclosure will be more apparent from the following description taken in conjunction with the accompanying drawings, in which:
FIG. 1 is a view illustrating an electronic device in a network environment according to an embodiment of the disclosure;
FIG. 2 is a view illustrating an unfolded state of an electronic device according to an embodiment of the disclosure;
FIG. 3 is a view illustrating a folded state of an electronic device according to an embodiment of the disclosure;
FIG. 4 is a cross-sectional view illustrating an electronic device including at least one light source and a heat dissipation sheet according to an embodiment of the disclosure;
FIG. 5 is a view illustrating a heat dissipation sheet according to an embodiment of the disclosure;
FIG. 6 is a view illustrating a heat dissipation sheet according to an embodiment of the disclosure;
FIG. 7 is a view illustrating a state in which a heat dissipation sheet surrounds at least one light source according to an embodiment of the disclosure;
FIG. 8 is a view illustrating a state in which a heat dissipation sheet surrounds at least one light source according to an embodiment of the disclosure;
FIG. 9 is a view illustrating a state in which a heat dissipation sheet surrounds at least one light source according to an embodiment of the disclosure;
FIG. 10 is a view illustrating a state in which light emitted from at least one light source reaches a surrounding component according to an embodiment of the disclosure;
FIG. 11 is a view illustrating a state in which light emitted from at least one light source reaches a surrounding component according to an embodiment of the disclosure;
FIG. 12 is a view illustrating an arrangement relationship between components included in a heat dissipation sheet according to an embodiment of the disclosure;
FIG. 13 is a side view of FIG. 12 according to an embodiment of the disclosure;
FIG. 14 is a view illustrating an arrangement relationship between components included in a heat dissipation sheet according to an embodiment of the disclosure;
FIG. 15 is a side view of FIG. 14 according to an embodiment of the disclosure;
FIG. 16 is a view illustrating a surface temperature of an electronic device according to an embodiment of the disclosure; and
FIG. 17 is a view illustrating a surface temperature of an electronic device according to an embodiment of the disclosure.

Throughout the drawings, like reference numerals will be understood to refer like parts, components, and structures.

### [Mode for the Invention]

The following description with reference to the accompanying drawings is provided to assist in a comprehensive understanding of various embodiments of the disclosure as defined by the claims and their equivalents. It includes various specific details to assist in that understanding, but these are to be regarded as merely exemplary. Accordingly, those of ordinary skill in the art will recognize that various changes and modifications of the various embodiments described herein can be made without departing from the scope and spirit of the disclosure. In addition, descriptions of well-known functions and constructions may be omitted for clarity and conciseness.

The terms and words used in the following description and claims are not limited to the bibliographical meanings, but are merely used by the inventor to enable a clear and consistent understanding of the disclosure. Accordingly, it should be apparent to those skilled in the art that the following description of various embodiments of the disclosure is provided for illustration purposes only and not for the purpose of limiting the disclosure as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

A thermistor may be disposed around the flash LED and the surroundings to monitor the temperature of the flash LED. After the temperature for the flash LED is monitored, research on means for controlling it may be required.

Previously, research for dissipating the heat generated in an electronic device was mainly to reduce resistance heat generated in a processor (e.g., an application processor), a power management module, and/or a camera module. In other words, the design for radiant heat generation for the flash LED is insufficient.

The flash LED emits higher radiant energy as the brightness of the light source increases, which may cause the temperature of the cover of the electronic device to increase. In particular, in the case of an electronic device having a structure in which a flash LED is disposed adjacent to a cover, thermal energy is accumulated in the cover of the electronic device and is maintained in a saturated state, which may cause inconvenience to the user.

Hereinafter, various embodiments for addressing the issue of LED heat generation may be provided in an electronic device having a structure such as a flash LED. In the disclosure, the above-described issues may be addressed by providing an electronic device including at least one light source and a heat dissipation sheet.

The following description taken in conjunction with the accompanying drawings may provide an understanding of various implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

It should be appreciated that the blocks in each flowchart and combinations of the flowcharts may be performed by one or more computer programs which include instructions. The entirety of the one or more computer programs may be stored in a single memory device or the one or more computer programs may be divided with different portions stored in different multiple memory devices.

Any of the functions or operations described herein can be processed by one processor or a combination of processors. The one processor or the combination of processors is circuitry performing processing and includes circuitry like an application processor (AP, e.g. a central processing unit (CPU)), a communication processor (CP, e.g., a modem), a graphics processing unit (GPU), a neural processing unit (NPU) (e.g., an artificial intelligence (AI) chip), a Wi-Fi chip, a Bluetooth^{®} chip, a global positioning system (GPS) chip, a near field communication (NFC) chip, connectivity chips, a sensor controller, a touch controller, a finger-print sensor controller, a display drive integrated circuit (IC), an audio CODEC chip, a universal serial bus (USB) controller, a camera controller, an image processing IC, a microprocessor unit (MPU), a system on chip (SoC), an integrated circuit (IC), or the like.

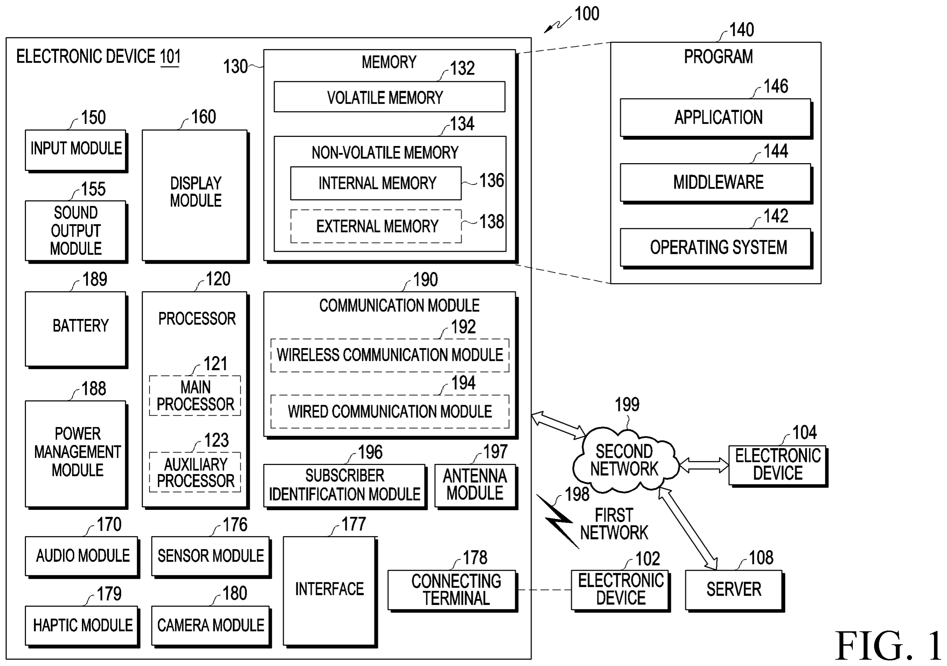

FIG. 1 is a view illustrating an electronic device in a network environment according to an embodiment of the disclosure.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a fifth generation (5G) network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a fourth generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multipleoutput (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

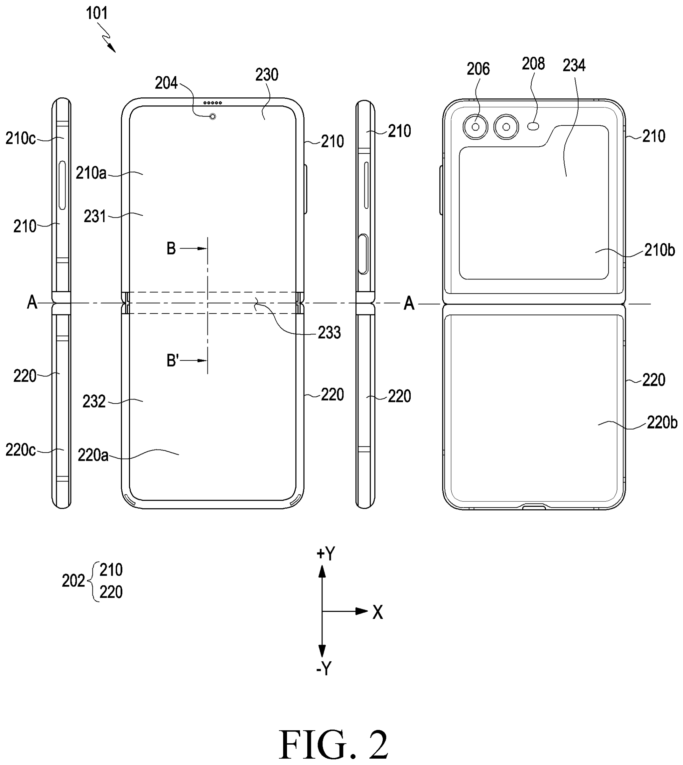

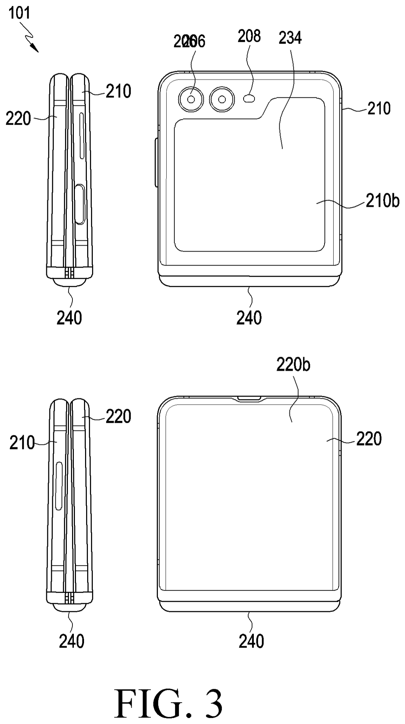

FIG. 2 is a view illustrating an unfolded state of an electronic device according to an embodiment of the disclosure. FIG. 3 is a view illustrating a folded state of an electronic device according to an embodiment of the disclosure.

The configuration of the electronic device 101 of FIGS. 2 and 3 may be identical in whole or part to the configuration of the electronic device 101 of FIG. 1.

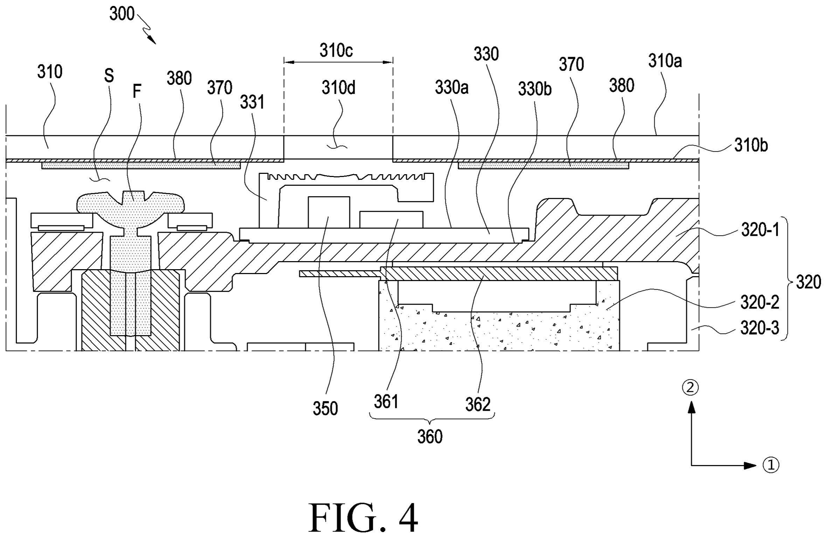

The embodiments of FIGS. 2 and 3 may be combined with the embodiment of FIG. 1 or the embodiments of FIGS. 4 to 15.

Referring to FIG. 2 and the subsequent figures, the length direction of the electronic device 101 may be defined as the 'Y-axis direction', the width direction as the 'X-axis direction', and/or the height direction (the thickness direction) as the 'Z-axis direction'. In the following detailed description, the mentioned length direction, width direction, and/or height direction (or thickness direction) may indicate the length direction, the width direction, and/or the height direction (or thickness direction) of the electronic device 10. In an embodiment, 'negative/positive (-/+)' may be mentioned together with the Cartesian coordinate system exemplified in the drawings with respect to the direction in which the component is oriented. Although not illustrated in FIG. 2, the arrangement relationship in the height direction of a component or another component, that is, the reference as to whether a component is on/under another component, may follow the +Z-axis direction/-Z-axis direction.

Referring to FIGS. 2 and 3, an electronic device 101 may include a housing 202 for receiving a component of the electronic device 101 and a flexible display (hereinafter, display 230) disposed in the space formed by the housing 202. According to an embodiment, the housing 202 may be referred to as a foldable housing. According to an embodiment, the display 230 may be referred to as a foldable display.

According to an embodiment, the housing 202 may include a first housing 210 and a second housing 220 configured to rotate about the first housing 210.

According to an embodiment, the first housing 210 and/or the second housing 220 may form a portion of the exterior of the electronic device 101. According to an embodiment, the surface where the display 230 is visually exposed may be defined as a front surface (e.g., a first front surface 210a and a second front surface 220a) of the electronic device 101 and/or housing 202. A surface opposite to the front surface may be defined as a rear surface (e.g., the first rear surface 210b and the second rear surface 220b) of the electronic device 101. A surface surrounding at least a portion of the space between the front surface and the rear surface may be defined as a side surface (e.g., the first side surface 210c and the second side surface 220c) of the electronic device 101.

According to an embodiment, the first housing 210 may be connected to the second housing 220 to be rotatable about the second housing 220 using a hinge structure. For example, the first housing 210 and the second housing 220 may be connected to each other to be rotatable about the hinge structure. Thus, the electronic device 101 may turn into a folded state (e.g., FIG. 3) or unfolded state (e.g., FIG. 2). In the folded state of the electronic device 101, the first front surface 210a may face the second front surface 220a and, in the unfolded state, the direction in which the first front surface 210a faces may be substantially the same as the direction in which the second front surface 220a faces. For example, in the unfolded state, the first front surface 210a may be positioned on substantially the same plane as the second front surface 220a. According to an embodiment, the second housing 220 may provide a motion relative to the first housing 210.

According to an embodiment, the first housing 210 and the second housing 220 may be disposed on both sides of the folding axis A and be overall symmetrical in shape with respect to the folding axis A. The angle between the first housing 210 and the second housing 220 may be changed depending on whether the electronic device 101 is in the unfolded state, the folded state, or an intermediate state between the unfolded state and the folded state.

According to an embodiment, the electronic device 101 may include a hinge cover 240. At least a portion of the hinge cover 240 may be disposed between the first housing 210 and the second housing 220. According to an embodiment, the hinge cover 240 may be hidden by a portion of the first housing 210 and second housing 220 or be exposed to the outside depending on the state of the electronic device 101. According to an embodiment, the hinge cover 240 may protect the hinge structure from an external impact of the electronic device 101. According to an embodiment, the hinge cover 240 may be interpreted as a hinge housing for protecting the hinge structure.

According to an embodiment, as shown in FIG. 2, in the unfolded state of the electronic device 101, the hinge cover 240 may be hidden, and thus not exposed, by the first housing 210 and the second housing 220. As another example, as shown in FIG. 3, in the folded state (e.g., a fully folded state) of the electronic device 101, the hinge cover 240 may be exposed to the outside between the first housing 210 and the second housing 220. As another example, in an intermediate state in which the first housing 210 and the second housing 220 are folded with a certain angle, the hinge cover 240 may be partially exposed to the outside between the first housing 210 and the second housing 220. However, in this case, the exposed area may be smaller than that in the completely folded state. In an embodiment, the hinge cover 240 may include a curved surface.

According to an embodiment, the display 230 may visually provide information to the outside (e.g., the user) of the electronic device 101. The display 230 may include, for example, a hologram device, or a projector and control circuitry to control a corresponding one of the display, hologram device, and projector. According to an embodiment, the display 230 may include a touch sensor configured to detect a touch, or a pressure sensor configured to measure the intensity of a force generated by the touch.

According to an embodiment, the display 230 may refer to a display at least a portion of which may be transformed into a flat or curved surface. For example, the display 230 may be formed to be transformable in response to the motion of the second housing 220 relative to the first housing 210. According to an embodiment, the display 230 may include a folding area 233, a first display area 231 disposed on one side of the folding area 233 (e.g., the upper (+Y) direction), and a second display area 232 disposed on the opposite side of the folding area 233 (e.g., lower (-Y) direction). According to an embodiment, the folding area 233 may be positioned above the hinge structure. For example, at least a portion of the folding area 233 may face the hinge structure. According to an embodiment, the first display area 231 may be disposed on the first housing 210, and the second display area 232 may be disposed on the second housing 220. According to an embodiment, the display 230 may be received in the first housing 210 and the second housing 220.

However, the segmentation of the display 230 as shown in FIG. 2 is merely an example, and the display 230 may be divided into a plurality of (e.g., four or more, or two) areas depending on the structure or function of the display 200.

Further, in the embodiment illustrated in FIG. 2, the area of the display 230 may be segmented by the folding area 233 or folding axis (axis A) extending in parallel with the X axis but, according to another embodiment of the disclosure, the display 230 may also be segmented with respect to other folding area (e.g., a folding area parallel with the Y axis) or other folding axis (e.g., a folding axis parallel with the Y axis). According to an embodiment, the display 230 may be coupled with or disposed adjacent to a touch detection circuit, a pressure sensor capable of measuring the strength (pressure) of touches, and/or a digitizer for detecting a magnetic fieldtype stylus pen.

According to an embodiment, the electronic device 101 may include a rear display 234. The rear display 234 may be disposed to face in a different direction from the display 230. For example, the display 230 may be visually exposed through the front surface (e.g., the first front surface 210a and/or the second front surface 220a) of the electronic device 101, and the rear display 234 may be visually exposed through the rear surface (e.g., the first rear surface 210b) of the electronic device 101.

According to an embodiments, the electronic device 101 may include at least one camera module 204 and 206 and a flash 208. According to an embodiment, the electronic device 101 may include a front camera module 204 exposed through the front surface (e.g., the first front surface 210a) and/or a rear camera module 206 exposed through the rear surface (e.g., the first rear surface 210b). The camera modules 204 and 206 may include one or more lenses, an image sensor, a flash, and/or an image signal processor. The flash 208 may include a light emitting diode (LED) or a xenon lamp. According to an embodiment, two or more lenses (e.g., an infrared (IR) camera, a wide-angle lens, and a telescopic lens) and image sensors may be disposed on one surface of the electronic device 101. The configuration of the front camera module 204 and/or rear camera module 206 may be identical in whole or part to the configuration of the camera module 180 of FIG. 1.

Hereinafter, a structure of an electronic device including at least one light source and a heat dissipation sheet and an arrangement relationship between components are described in detail with reference to the embodiments of FIGS. 4 to 15.

FIG. 4 is a cross-sectional view illustrating an electronic device including at least one light source and a heat dissipation sheet according to an embodiment of the disclosure. FIG. 4 may illustrate a cross section of an electronic device including a flash 208 and components adjacent thereto in the electronic device 101 of FIGS. 2 and 3.

Referring to FIG. 4 and subsequent figures, direction component ①, direction component ②, and direction component ③ are illustrated. The direction component ①, the direction component ②, and the direction component ③ are direction components orthogonal to each other, and may correspond to the coordinate axes Y, Z, and X of FIG. 2, respectively, but are not necessarily limited thereto. The direction component ①, the direction component ②, and the direction component ③ may be interpreted as facing in directions different from the coordinate axes Y, Z, and X according to an embodiment. When an element is disposed above another element, it may mean that the element is disposed above the other element on the direction component ②, and when an element is disposed under another element, it may mean that the element is disposed under the other element on the direction component . Meanwhile, it should be noted that although a component is disposed on or under another component, it does not necessarily mean that the entire component is disposed on or under the entire other component. For example, it should be noted that a portion of the component may be disposed on a portion of the other component while another portion of the component may be disposed under another portion of the other component. In the following description, it should be noted that when a component overlaps (or is stacked on) another component, the above description of the arrangement relationship in height direction may apply.

The electronic device 300 may include a cover 310.

The cover 310 may be an element defining the front surface (e.g., the first front surface 210a and the second front surface 220a) of the electronic device 101 and/or the housing 202 described above with reference to FIGS. 2 and 3. Alternatively, the cover 310 may be an element defining the rear surface (e.g., the first rear surface 210b and the second rear surface 220b) of the electronic device 101 and/or the housing 202 described above with reference to FIGS. 2 and 3. According to various embodiments, the cover 310 may be an element defining a side surface of the electronic device 101 and/or the housing 202. Hereinafter, in describing various embodiments of the disclosure, the cover 310 defining the rear surface of the electronic device 101 may be described as an example with reference to FIGS. 2 to 4.

The cover 310 may be formed of a glass plate or a resin (or polymer) plate. The housing may include a substantially opaque plate in addition to the cover 310, but a detailed description thereof may be omitted. The glass plate may be a glass plate including various coating layers, e.g., coated or colored glass. According to an embodiment, the glass plate may be a window glass to protect the display from external physical/chemical impacts. At least a portion of the polymer plate may be a transparent polymer plate. The polymer plate may include, e.g., a polycarbonate-based material, a poly sulfone-based material, a poly acrylate-based material, a poly styrenebased material, a poly vinyl chloride-based material, a poly vinyl alcohol-based material, a poly norbornene-based material, and a polyester-based material.

When the cover 310 is transparently formed, internal components of the electronic device may be visually exposed to the outside in whole or in part. This may be a factor that degrades the aesthetics of the electronic device. Accordingly, an anti-visibility sheet 380 provided to prevent internal components of the electronic device from being visually exposed to the outside may be formed on the rear surface of the cover 310. The anti-visibility sheet 380 may be, e.g., a masking film and/or a masking tape, and may be coated with a coating material for preventing visibility or colored with a color for preventing visibility.

In the inner space S of the electronic device, various component(s) 360, component(s) (e.g., at least one supporting member (hereinafter, referred to as "at least one bracket 320")) for supporting the component, and fastening member(s) F for fastening any component to another component may be provided.

The various component(s) 360 disposed in the inner space S of the electronic device may be diverse, e.g., such as a processor (e.g., one or more of a central processing unit, an application processor, a graphics processing unit, an image signal processor, a sensor hub processor, or a communication processor), memory, a power management module, a battery, a communication module, an audio module, a battery, and various sensors. The various component(s) 360 may include a printed circuit board (e.g., the substrate 330) on which various signal lines are wired. FIG. 4 illustrates at least one light source 350, a sensor 361, and an audio module 362 as examples of various component(s) 360. However, the disclosure is not necessarily limited thereto, and other components may be added or omitted according to embodiments.

The at least one bracket 320 may be disposed in the inner space S of the electronic device to be connected to the housing and/or the cover 310 of the electronic device 300, or may be integrally formed with the housing and/or the cover 310. The at least one bracket 320 may be formed of, e.g., a metallic material and/or a non-metallic (e.g., polymer) material. The at least one bracket 320 may include, e.g., a first bracket 320-1, a second bracket 320-2, and a third bracket 320-3. According to an embodiment, the electronic device may omit at least one (e.g., the second bracket 320-2 or the third bracket 320-3) of the components or may further include other components. The printed circuit board 330 may be disposed on at least one of the at least one bracket 320, e.g., one surface of the first bracket 320-1.

Referring to FIG. 4, an embodiment in which a plurality of components are disposed on the printed circuit board 330 is illustrated. For example, as a plurality of components, at least one light source 350 and a sensor 361 may be disposed on the first surface 330a of the printed circuit board 330. The second surface 330b of the printed circuit board 330 may be seated on one surface of the first bracket 320-1. As another example, the lens structure 331 may be disposed on the printed circuit board 330. The lens structure 331 may include a lens that refracts light so that the light emitted from the at least one light source 350 moves toward a predetermined angle while passing through the lens structure 331. For example, the lens structure 331 may include a Fresnel lens.

The electronic device 300 may emit light to the outside of the electronic device 300 using at least one light source 350. For example, the electronic device may emit light from the at least one light source 350 according to various uses such as using it as a flashlight in an emergency, or transmitting/receiving a message such as a phone call, a text message, and/or displaying a notification such as an alarm. The light emitted from the at least one light source 350 may be radially spread from the at least one light source 350 and then bent at a designated angle while passing through the lens structure 331.

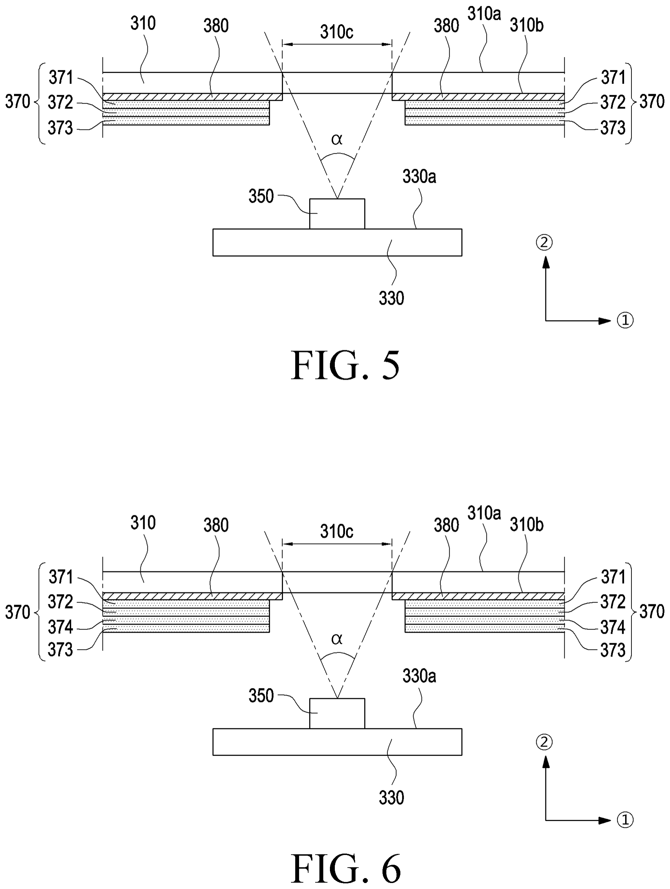

The cover 310 may include a light transmission portion 310c for transmitting light emitted from the at least one light source 350 to the outside, and the light transmission portion 310c may be aligned so that its center matches the center of the at least one light source 350. The light emitted from the at least one light source 350 is designed to spread through the light transmission portion 310c while having a predetermined angle of view (hereinafter, referred to as angle α of FIGS. 5 and 6). The light emitted from the at least one light source 350 reaches the cover 310 around the light transmission portion 310c. However, since the cover 310 around the light transmission portion 310c is not transparent, light energy may accumulate and the temperature of the cover 310 may rise.

In order to reduce the radiant energy accumulated in the cover 310 in this operation, in the disclosure, a heat dissipation sheet 370 may be additionally provided on the rear surface (or lower portion) of the cover 310. The heat dissipation sheet 370 may be disposed to surround at least a portion of the light transmission portion 310c.

According to an embodiment, the light transmission portion 310c of the cover 310 may include an opening 310d penetrating from the first surface 310a to the second surface 310b of the cover 310. In this case, the electronic device 300 may further include a dustproof and/or waterproof structure that prevents foreign substances or moisture from entering from the outside through the opening 310d.

Hereinafter, the heat dissipation sheet 370 is described in detail with reference to the embodiments of FIGS. 5 and 6.

FIG. 5 is a view illustrating a heat dissipation sheet according to an embodiment of the disclosure. FIG. 6 is a view illustrating a heat dissipation sheet according to an embodiment of the disclosure.

Referring to FIGS. 5 and 6, the heat dissipation sheet 370 may include a heat diffusion member 372 and a light reflection member 373. The heat dissipation sheet 370 may be attached to the second surface 310b of the cover 310. The heat dissipation sheet 370 may be attached to the second surface 310b of the cover 310 using the first adhesive member 371. As described above, the anti-visibility sheet 380 may be provided on the second surface 310b of the cover 310. In this case, the heat dissipation sheet 370 may be disposed on the rear surface (lower) of the anti-visibility sheet 380. The heat dissipation sheet 370 may be a structure in which the first adhesive member 371, the heat diffusion member 372, and the light reflection member 373 are stacked. For example, the heat dissipation sheet 370 may be attached to the cover 310 using the first adhesive member 371, and may have a structure in which the heat diffusion member 372 and the light reflection member 373 are sequentially stacked on the first adhesive member 371. Referring to FIGS. 4 and 5 together, when the heat dissipation sheet 370 is disposed on the rear surface of the cover 310, the heat dissipation sheet 370 may at least partially overlap the printed circuit board 330 on which the at least one light source 350 is disposed, and the light reflection member 373 may face the first surface 330a of the printed circuit board 330. The light reflection member 373 is disposed at a position where light emitted from the at least one light source 350 is obliquely incident with respect to the light reflection member 373, so that the light may be reflected away from the light transmission portion 310c.

The first adhesive member 371 may serve to attach the heat diffusion member 372 to the rear surface of the cover 310. The first adhesive member 371 may include, e.g., an optically clear adhesive (OCA), an optically clear resin (OCR), and/or a pressure sensitive adhesive (PSA).

The heat diffusion member 372 is a structure disposed to overlap and/or be stacked with the light reflection member 373, and may serve to reduce and/or prevent energy accumulated while the light reflection member 373 reflects light from being concentrated at one point of the housing and/or the cover 310, and to spread energy. The heat diffusion member 372 may include the heat diffusion material. Various materials, e.g., graphite may be applied as the heat diffusion material. However, this is merely an example, and it should be noted that the heat diffusion member 372 may additionally or alternatively include a high heat conductive material such as a solid phase or liquid phase thermal interface material (TIM), graphite, carbon nanotubes, silicon, or the like.

According to an embodiment, an insulation material may be further included, in addition to, or as an alternative to, the heat diffusion member 372. The heat insulation material may block the energy accumulated while the light reflection member 373 reflects light from reaching the energy and/or the cover 310. Various materials, such as poron (TM), cork, magnesium powder, calcium silicate, pearlite, aluminum foil, or porous refractory material may be applied as the heat insulation material. However, the type of the heat insulation material is not limited and may vary according to embodiments. According to an embodiment of the disclosure, since a heat insulation material may be provided in addition to or as an alternative to the heat diffusion member, the heat diffusion member may be referred to as a heat diffusion member and/or heat insulation material.

The light reflection member 373 may be a component for reflecting light emitted from the at least one light source 350 and may include, e.g., at least one of a light reflective film, a light reflective tape, and a mirror. According to an embodiment illustrated in FIG. 6, a second adhesive member 374 may be provided between the heat diffusion member and the light reflection member to firmly couple at least one of the light reflective film, the light reflective tape, and the mirror with the heat diffusion member 372. In this case, the material of the second adhesive member 374 may be the same as that of the first adhesive member 371. In addition to the above-described embodiment, the light reflection member 373 may be formed by applying a light reflecting material on the heat diffusion member.

According to various embodiments of the disclosure, due to the stacked structure of the light reflection member 373 and the heat diffusion member 372, radiant energy transferred from the at least one light source 350 may be spread. In this case, the efficiency of spreading the radiant energy, i.e., the thermal diffusion performance, may vary depending on the material and/or color of the light reflection member 373, and the material and/or thickness of the heat diffusion member 372.

For example, when the light reflection member 373 is formed of a film and the heat diffusion member 372 includes graphite having a predetermined thickness, the difference in heat diffusion performance according to the color of the light reflection member 373 may be identified with reference to Table 1 below. As a comparative example of the difference in heat diffusion performance according to the color of the light reflection member 373, an embodiment (e.g., embodiment 1) in which a heat dissipation sheet without a light reflection member is applied and an embodiment (e.g., embodiment 5) in which a mirror is applied as the light reflection member 373 are further disclosed. The difference in heat diffusion performance may be represented as a result of measuring the temperature of the cover 310 at the position where the heat dissipation sheet 370 is disposed, compared to measuring the temperature of the cover 310 in the state where the heat dissipation sheet 370 is not provided.

**Table 1**

| Types | Embodiment 1 | Embodiment 2 | Embodiment 3 | Embodiment 4 | Embodiment 5 |
|---|---|---|---|---|---|
| whether light reflection member and heat diffusion member applied | only graphite applied | black color film and graphite applied | gray color film and graphite applied | white color film and graphite applied | mirror and graphite applied |
| measuring temperature | -2.5°C | -1°C | -4.5°C | -6°C | -6.5°C |

As shown in Table 1, even when graphite is applied as the heat diffusion member 372, the temperature decreases by -1 degrees when the light reflection member 373 has a black color that absorbs heat, the temperature decreases by -2.5 degrees when only graphite is applied as the heat diffusion member 372, the temperature decreases by -4.5 degrees when the light reflection member 373 has a gray color, and the temperature decreases by -6 degrees when the light reflection member 373 has a white color that reflects heat. When the light reflection member 373 is a mirror formed of a material that completely reflects heat, the light reflection member 373 decreases by -6.5 degrees and the temperature decreases the most. Accordingly, as shown in Table 1, the temperature of the cover 310 may be remarkably reduced at the position where the heat dissipation sheet 370 is disposed by appropriately adjusting the material and/or color of the light reflection member 373, the material and/or thickness of the heat diffusion member 372. In the disclosure, the LED heat generation problem described above in the background section may be efficiently solved by including the heat dissipation sheet 370 referred to in FIGS. 4 to 6. Hereinafter, various embodiments related to the heat dissipation sheet 370 are described in detail.

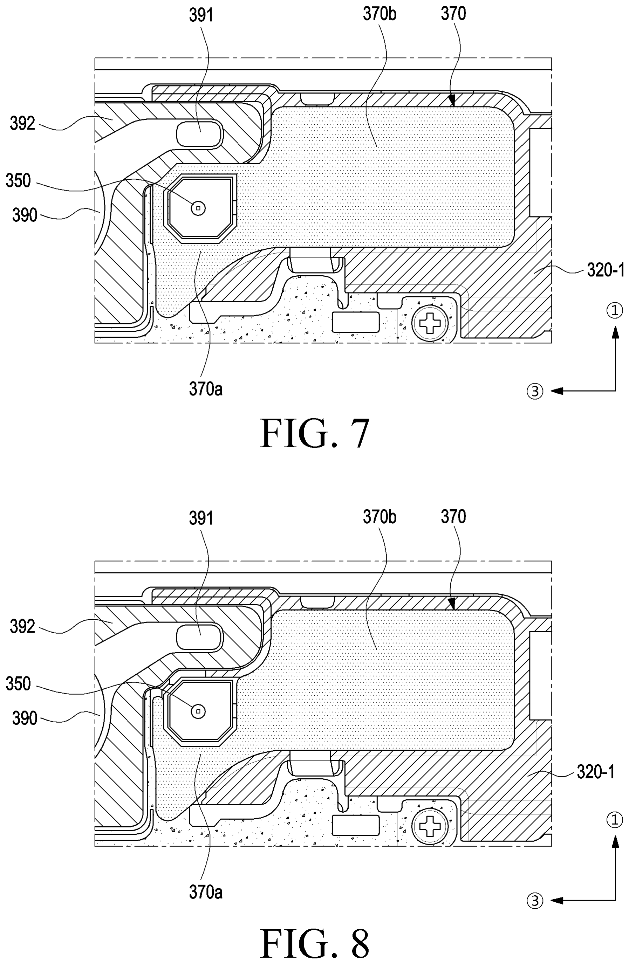

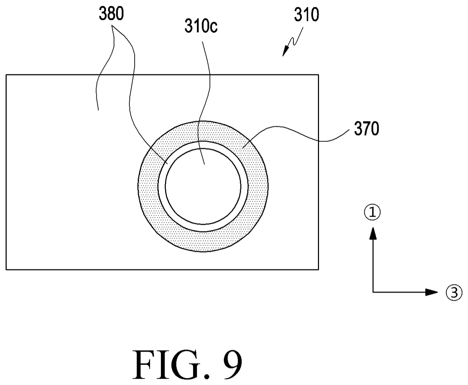

FIG. 7 is a view illustrating a state in which a heat dissipation sheet surrounds at least one light source according to an embodiment of the disclosure. FIG. 8 is a view illustrating a state in which a heat dissipation sheet surrounds at least one light source according to an embodiment of the disclosure. FIG. 9 is a view illustrating a state in which a heat dissipation sheet surrounds at least one light source according to an embodiment of the disclosure.

FIGS. 7 and 8 illustrate a state in which components inside the electronic device are viewed when the cover of the rear surface 210b is removed in the embodiment illustrated in FIGS. 2 and 3, and FIG. 9 illustrates a state in which a second surface of the cover is viewed. Referring to FIGS. 7 and 9, the heat dissipation sheet 370 may have a shape surrounding at least one light source 350 as a whole. Referring to FIG. 8, the heat dissipation sheet 370 may partially surround at least one light source 350.

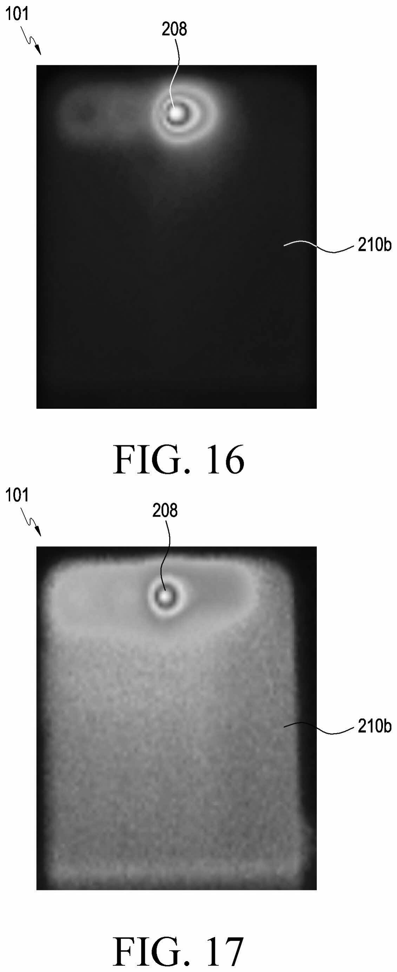

The heat dissipation sheet 370 may include a first portion surrounding at least a portion of the light transmission portion and a second portion 370b extending from the first portion 370a. Referring to FIG. 7, when the first portion 370a of the heat dissipation sheet 370 is viewed from above, it may appear to surround all of the at least one light source 350. The second portion 370b is a portion extending from the first portion 370a to one side, and according to an embodiment, may have a larger area than the first portion 370a in the heat dissipation sheet 370. According to an embodiment, the second portion 370b may be disposed to face at least one bracket (e.g., the first bracket 320-1). As the heat dissipation sheet 370 includes the first portion 370a and the second portion 370b, it is possible to reduce and/or prevent heat from being concentrated around the light transmission portion. Hereinafter, as is described below in the embodiment illustrated in FIG. 17, as the second portion 370b is disposed to face above at least one bracket (e.g., the first bracket 320-1), heat may be dispersed toward the second portion 370b.

Referring to FIG. 8, when the first portion 371 of the heat dissipation sheet 370 is viewed from above, it is illustrated as surrounding only a portion of the heat dissipation sheet 370 rather than surrounding all of the at least one light source 350. This may be a design of the heat dissipation sheet 370 to have a predetermined tolerance without interfering with a component disposed around the at least one light source 350.

According to another embodiment illustrated in FIG. 9, the heat dissipation sheet 370 may have a shape surrounding only the light transmission portion 310c. In this case, the second portion 370b facing above the at least one bracket (e.g., the first bracket 320-1) in the heat dissipation sheet 370 may be omitted.

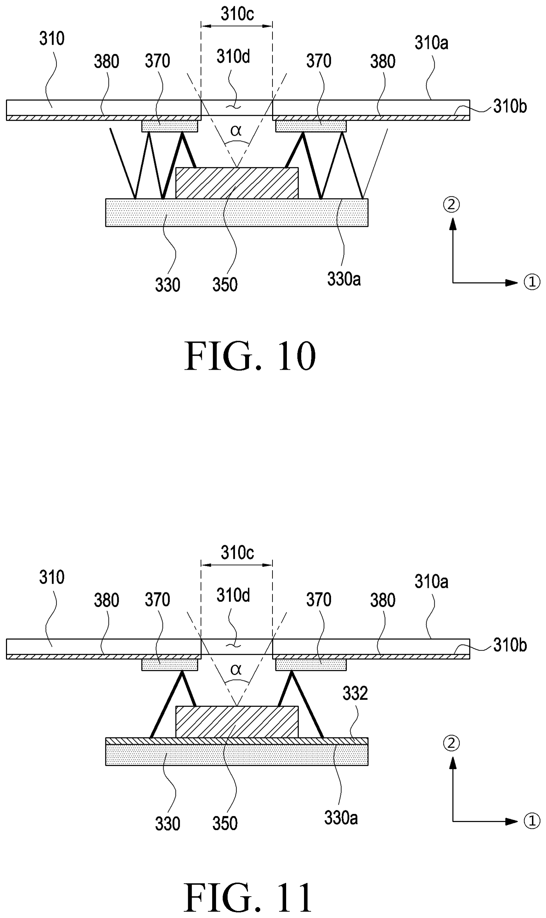

FIG. 10 is a view illustrating a state in which light emitted from at least one light source reaches a surrounding component according to an embodiment of the disclosure. FIG. 11 is a view illustrating a state in which light emitted from at least one light source reaches a surrounding component according to an embodiment of the disclosure.

Referring to FIG. 10, the light emitted from the at least one light source 350 may reach components around the light transmission portion 310c except for the light passing through the light transmission portion 310c. As illustrated in FIG. 10, if the heat dissipation sheet 370 is included, light reaching around the light transmission portion 310c may be reflected, thereby reducing and/or preventing heat from accumulating in the cover 310. The light reflected from the heat dissipation sheet 370 may again reach the substrate 330 around the at least one light source 350. According to an embodiment, the substrate 330 may have a bright color. For example, the substrate 330 may have a white color. According to another example, the substrate 330 may have a bright gray color. Other various bright colors may be applied to the substrate 330. The substrate 330 disposed adjacent to the cover 310 may be viewed through the cover 310 when viewed from outside of the cover 310 although having the anti-visibility sheet 380 on the second surface 310b of the cover 310. When the substrate 330 has a white color, the overall aesthetics of the electronic device may be prevented from deteriorating although the substrate 330 is partially viewed. In this case, the light reaching the first surface 330a of the substrate 330 may be reflected to reach the heat dissipation sheet 370. The light reaching the heat dissipation sheet 370 may be reflected again to reach the substrate 330. The light reaching the substrate 330 may be reflected again and partially absorbed into the anti-visibility sheet 380. By having a structure in which light is reflected several times around the light transmission portion 310c, it is possible to have an effect of dispersing heat without being concentrated in a partial area of the cover 310.

Referring to FIG. 11, the light emitted from the at least one light source 350 may reach components around the light transmission portion 310c except for the light passing through the light transmission portion 310c. The light reflected from the heat dissipation sheet 370 may again reach the substrate 330 around the at least one light source 350. According to an embodiment, the substrate 330 may have a dark color. For example, the substrate 330 may have a black color. According to another example, the substrate 330 may have a dark gray color. Other various dark colors may be applied to the substrate 330. According to an embodiment, the black color on the substrate 330 may be implemented by applying a paint including the light absorbing material 332 or attaching a light absorbing film and/or tape including the light absorbing material 332. The light reaching the first surface 330a of the substrate 330 may be absorbed by the light absorbing material 332 without being reflected again. As such, since the light is not accumulated around the light transmission portion 310c and is absorbed by the substrate 330, heat may be dispersed without being concentrated in a partial area of the cover 310.

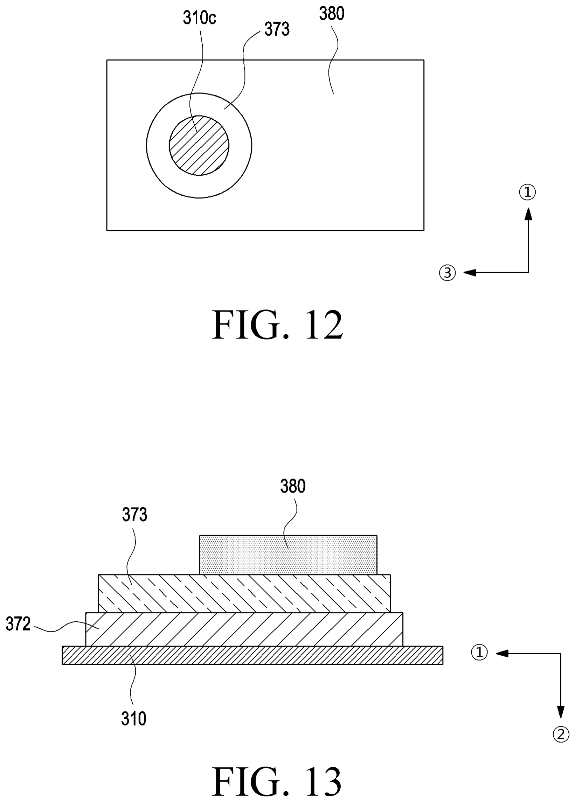

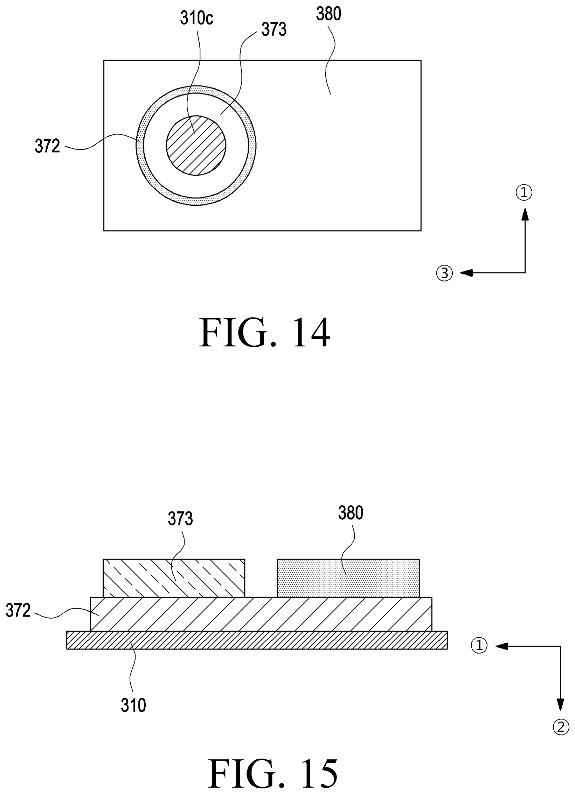

FIG. 12 is a view illustrating an arrangement relationship between components included in a heat dissipation sheet according to an embodiment of the disclosure. FIG. 13 is a side view of FIG. 12 according to an embodiment of the disclosure. FIG. 14 is a view illustrating an arrangement relationship between components included in a heat dissipation sheet according to an embodiment of the disclosure. FIG. 15 is a side view of FIG. 14 according to an embodiment of the disclosure.

Referring to FIGS. 12 - 15, the heat diffusion sheet 372 may be disposed on the cover 310, and the light reflection member 373 may be disposed on the heat diffusion sheet 372. This is a basic structure for the heat dissipation sheet of the disclosure, and it should be noted that the adhesive member is omitted for convenience in the embodiments of FIGS. 12 to 16.

Referring to FIGS. 12 and 13, the heat dissipation sheet may further include a light absorption member 381 on the light reflection member 373. The light absorption member 381 may include a light absorbing material and may serve to absorb light emitted from at least one light source. By further including the light absorption member 381, it is possible to reduce and/or prevent light from being reflected again in the internal space (e.g., the internal space S of FIG. 4) of the electronic device. The light absorption member 381 may be provided in addition to or as an alternative to the anti-visibility sheet 380 illustrated in FIG. 4. When the inner space (e.g., the inner space S of FIG. 4) of the electronic device is roomy, the heat dissipation sheet illustrated in FIGS. 12 and 13 may be applied.

Referring to FIGS. 14 and 15, the heat dissipation sheet may further include a light absorption member 382 disposed at a position adjacent to the light reflection member 373 and spaced apart from the light reflection member 373 by a predetermined distance. The light absorption member 382 may include a light absorbing material and may serve to absorb light emitted from at least one light source. By further including the light absorption member 382, it is possible to reduce and/or prevent light from being reflected again in the internal space (e.g., the internal space S of FIG. 4) of the electronic device. The light absorption member 382 of FIGS. 14 and 15 may be provided to replace the light absorption member 381 of FIGS. 12 and 13. The light absorption member 382 of FIGS. 14 and 15 may be provided in addition to or as an alternative to the anti-visibility sheet 380 illustrated in FIG. 4. When the inner space (e.g., the inner space S of FIG. 4) of the electronic device is narrow or a wider mounting space is to be secured for other electronic components, the heat dissipation sheet illustrated in FIGS. 14 and 15 may be applied.

FIG. 16 is a view illustrating a surface temperature of an electronic device according to an embodiment of the disclosure. FIG. 17 is a view illustrating a surface temperature of an electronic device according to an embodiment of the disclosure.

FIG. 16 is a view illustrating an electronic device in which a flash reaches a saturation temperature while power is turned on for a designated time according to an embodiment of the disclosure. FIG. 17 may be a view illustrating an electronic device to which a heat dissipation sheet described with reference to the embodiments of FIGS. 4 to 15 is applied, wherein a flash provided on a rear surface reaches a saturation temperature while power is turned on for a designated time.

FIG. 16 illustrates that the center temperature is measured at 60.5 degrees in the light transmission portion corresponding to the flash, and FIG. 17 illustrates that the center temperature is measured at 53.4 degrees in the light transmission portion corresponding to the flash. FIG. 16 illustrates an embodiment in which a heat dissipation sheet is not provided, and FIG. 17 illustrates an embodiment in which a heat dissipation sheet is provided. It may be identified that when the heat dissipation sheet of the disclosure is applied, the surface temperature of the electronic device is enhanced by 7 degrees or more with respect to the saturation temperature. The surface temperature of the electronic device may be lowered due to the heat dissipation sheet disposed on the rear surface of the cover. As illustrated in FIG. 16, it may be identified that when the heat dissipation sheet is not provided, heat may be concentrated on the light transmission portion of the cover but, as illustrated in FIG. 17, when the heat dissipation sheet is provided, the heat concentrated on the light transmission portion of the cover diffuses to the surroundings due to the heat dissipation sheet, and the surface temperature of the electronic device overall decreases.

The electronic device according to various embodiments may be one of various types of devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

An electronic device 101 or 300 according to an embodiment of the disclosure may comprise a cover 310 including a first surface 310a which is a portion of an outer surface of the electronic device and a second surface 310b facing in a direction opposite to the first surface, and including a light transmission portion 310c, a substrate 330 disposed in an inner space S of the electronic device, a light source 350 disposed on the substrate 330 to emit light through the light transmission portion 310c, and a heat dissipation sheet 370 attached on the second surface of the cover to surround at least a portion of the light transmission portion. The heat dissipation sheet 370 may include a heat diffusion member 372, and a light reflection member 373.

According to an embodiment, the cover may be disposed on a rear side of the electronic device. The light source may include a light emitting diode LED configured to emit flash light. The light reflection member may be configured to reflect a portion of the flash light emitted by the light source. The heat dissipation sheet may be disposed between the light reflection member and the cover.

According to an embodiment, the cover may be disposed on a front side of the electronic device. The light source may include a light emitting diode LED configured to emit flash light, The light reflection member may be configured to reflect a portion of the flash light emitted by the light source. The heat dissipation sheet may be disposed between the light reflection member and the cover.

According to an embodiment, the cover may include a glass plate or a resin plate.

According to an embodiment, the at least one light source 350 may include a light emitting diode or a xenon lamp.

According to an embodiment, the light transmission portion 310c may include an opening 310d penetrating from a first surface to a second surface.

According to an embodiment, the heat diffusion member may be formed of the graphite material.

According to an embodiment, the light reflection member may include at least one of a light reflective film, a light reflective tape, and a mirror.

According to an embodiment, the electronic device may further comprise an adhesive member disposed between the heat diffusion member and the second surface of the cover.

According to an embodiment, the light reflection member may be formed by coating a light reflecting material on the heat diffusion member.

According to an embodiment, the electronic device may further comprise an anti-visibility sheet 380 formed on the second surface of the cover. he heat dissipation sheet may be disposed on a rear surface of the anti-visibility sheet.

According to an embodiment, the electronic device may further comprise a light absorption member disposed on the light reflection member.

According to an embodiment, the anti-visibility sheet may have a dark color to absorb light.

According to an embodiment, the electronic device may further comprise a light absorption member disposed adjacent to the light reflection member.

According to an embodiment, the light reflection member may have a bright color for reflecting light.

According to an embodiment, the substrate may have a bright color.

According to an embodiment, the substrate may have a dark color.

According to an embodiment, the electronic device may further comprise at least one bracket disposed in the inner space of the electronic device. The substrate may be disposed on the at least one bracket.

According to an embodiment, the heat dissipation sheet may include a first portion surrounding at least a portion of the light transmission portion and a second portion extending from the first portion. The second portion of the heat dissipation sheet may be disposed to face the at least one bracket.

An electronic device 101 or 300 according to an embodiment of the disclosure may comprise a cover 310 including a first surface 310a which is a portion of an outer surface of the electronic device and a second surface 310b facing in a direction opposite to the first surface, and including a light transmission portion 310c, a substrate 330 disposed in an inner space S of the electronic device, a light source 350 disposed on the substrate 330 to emit flash light through the light transmission portion 310c, and a light reflection member 373 attached on the second surface of the cover to surround at least a portion of the light transmission portion. The light reflection member 373 may be configured to reflect a portion of the flash light, emitted by the light source, in a direction toward the inner space from the cover.

According to an embodiment, the electronic device may further comprise a heat diffusion member. The heat diffusion member may be disposed between the light reflection member and the cover.

According to an embodiment, the electronic device may further comprise a heat insulation member. The heat insulation member may be disposed between the light reflection member and the cover.

According to an embodiment, the electronic device may further comprise a light absorption member disposed on the light reflection member.

According to an embodiment, the electronic device may further comprise a light absorption member disposed adjacent to the light reflection member.

According to an embodiment, the cover may include a glass plate disposed on a front or rear surface of the electronic device, or a polymer plate including a substantially transparent portion.

According to an embodiment, the light transmission portion 310c may include an opening 310d penetrating a first surface and a second surface.

According to an embodiment, the heat diffusion member and/or the heat insulation member may include. The light reflection member may include at least one of a light reflective film, a light reflective tape, and a mirror. The electronic device may include a second adhesive member 374 disposed between the heat diffusion member and/or the heat insulation member.

According to an embodiment, the heat diffusion member and/or the heat insulation member may include graphite. The light reflection member may be formed to be coated with a light reflecting material

An electronic device 101 or 300 according to an embodiment of the disclosure may comprise a cover 310 including a first surface 310a and a second surface 310b facing in a direction opposite to the first surface, and including a light transmission portion 310c in a portion thereof, a substrate 330 disposed in an inner space S of the electronic device, a light source 350 disposed on the substrate 330 to emit flash light through the light transmission portion 310c, and a heat dissipation sheet 370 disposed on the second surface of the cover to surround at least a portion of the light transmission portion. The heat dissipation sheet 370 may include a heat insulation member 372 and a light reflection member 373. The heat dissipation sheet 370 may be attached on the second surface 310b of the cover 310.

While the disclosure has been shown and described with reference to various embodiments thereof, it will be understood by those skilled in the art that various changes in form and details may be made therein without departing from the overall scope of the disclosure as defined by the appended claims and their equivalents.

## Claims

1. An electronic device (101; 300) comprising:
a cover (310) including a first surface (310a) which is a portion of an outer surface of the electronic device and a second surface (310b) facing in a direction opposite to the first surface, and including a light transmission portion (310c);
a substrate (330) disposed in an inner space (S) of the electronic device;
a light source (350) disposed on the substrate (330) to emit light through the light transmission portion (310c); and
a heat dissipation sheet (370) attached on the second surface of the cover to surround at least a portion of the light transmission portion,
wherein the heat dissipation sheet (370) includes:
a heat diffusion member (372); and
a light reflection member (373).

2. The electronic device of claim 1,
wherein the cover is disposed on a rear side of the electronic device,
wherein the light source includes a light emitting diode (LED) configured to emit flash light,
wherein the light reflection member is configured to reflect a portion of the flash light emitted by the light source, and
wherein the heat dissipation sheet is disposed between the light reflection member and the cover.

3. The electronic device of claim 1,
wherein the cover is disposed on a front side of the electronic device,
wherein the light source includes a light emitting diode (LED) configured to emit flash light,
wherein the light reflection member is configured to reflect a portion of the flash light emitted by the light source, and
wherein the heat dissipation sheet is disposed between the light reflection member and the cover.

4. The electronic device of any one of claims 1 to 3,
wherein the cover comprises a glass plate or a resin plate.

5. The electronic device of any one of claims 1 to 4,
wherein the heat diffusion member is formed of a graphite material.

6. The electronic device of any one of claims 1 to 5,
wherein the light reflection member includes at least one of a light reflective film, a light reflective tape, and a mirror.

7. The electronic device of any one of claims 1 to 6, further comprising an adhesive member disposed between the heat diffusion member and the second surface of the cover.

8. The electronic device of any one of claims 1 to 5,
wherein the light reflection member is formed by coating a light reflecting material on the heat diffusion member.

9. The electronic device of any one of claims 1 to 8, further comprising an anti-visibility sheet formed on the second surface of the cover, wherein the heat dissipation sheet is disposed on a rear surface of the anti-visibility sheet.

10. The electronic device of any one of claims 1 to 9, further comprising a light absorption member disposed on the light reflection member.

11. The electronic device of any one of claims 1 to 10,
wherein the light reflection member has a bright color for reflecting light.

12. The electronic device of any one of claims 1 to 11, further comprising a light absorption member disposed adjacent to the light reflection member.

13. The electronic device of any one of claims 1 to 11,
wherein the substrate has a dark color.

14. The electronic device of any one of claims 1 to 13, further comprising at least one bracket disposed in the inner space of the electronic device,
wherein the substrate is disposed on the at least one bracket.

15. The electronic device of any one of claims 1 to 14,
wherein the heat diffusion member includes at least one of a heat diffusion material, a heat conductive material or, a heat insulation material.
